Europäisches Patentamt

European Patent Office

Office européen des brevets

(19)

(11) Publication number: **0 389 028**
**A2**

# EUROPEAN PATENT APPLICATION

(21) Application number: **90200555.2**

(22) Date of filing: **09.03.90**

(51) Int. Cl.⁵: **H01L 21/90, H01L 21/311**

(30) Priority: **23.03.89 IT 1988489**

(43) Date of publication of application:
**26.09.90 Bulletin 90/39**

(84) Designated Contracting States:
**DE FR GB NL SE**

(71) Applicant: **SGS-THOMSON
MICROELECTRONICS s.r.l.**
**Via C. Olivetti, 2**
**I-20041 Agrate Brianza Milano(IT)**

(72) Inventor: **Masini, Luisa**
**Via Bianco Mario 3**
**I-20131 Milano(IT)**
Inventor: **Sali, Mario**
**Via Ximenes 4**
**I-20125 Milano(IT)**

(74) Representative: **Mittler, Enrico et al**
**c/o Marchi & Mittler s.r.l. Viale Lombardia, 20**
**I-20131 Milano(IT)**

(54) **Planarization process for EPROM memory cell matrices with a table cloth and a half table cloth structure.**

(57) The EPROM cell matrix to be subjected to planarization comprises, on a semiconductor substratum (1), lines of source (2) and drain (3), between which there exist "packages" formed by a stratum of floating gate (5), a stratum of dielectric (6) and a stratum of barrier polysilicon (7).

The planarization process includes the deposition of a stratum of oxide (9) obtained from a liquid source, the deposition of sacrificial material (10) which is distributed by means of fast rotation, and the etching of these two materials (9, 10) with a plasma, whose rate of etching of the sacrificial material (10) is lower than the rate of etching of the oxide (9).

Fig.3

## Planarization process for EPROM memory cell matrices with a table cloth and a half table cloth structure.

The present invention relates to a planarization process for EPROM memory cell matrices with a table cloth and a half table cloth structure.

There are known EPROM memory cell matrices with a so-called "table cloth" structure, that is with drain and source lines alternated with one another on a semiconductor substrate, floating gate areas placed in a checker-board pattern between said source and drain lines and control gate lines parallel to one another and perpendicular to said source lines and drain lines in a condition superimposed over and aligned with said floating gate areas.

Several forms of table cloth structures have been proposed so far, from the original one described in Italian patent application No. 23479 A/84 dated November 7 1984 in the name of the same Applicant, to the more recent one of Italian patent application No. 22848 A/88 dated December 5 1988, again in the name of the same Applicant.

In particular, in the latter patent application there is described a process for the manufacture of an EPROM memory cell matrix with a table cloth structure, wherein there are defined strips of active areas alternated with parallel bars of field oxide on a semiconductor substrate, there are then caused to grow in succession gate oxide, a stratum of floating gate, a stratum of dielectric and a strutum of barrier polysilicon. A self-aligned etching of these strata is subsequently executed, until parallel strips of the substrate are uncovered for the implantation of the drain and source lines.

The planarization stage then follows, wherein there occur in succession the deposition of a stratum, preferably having a thickness ranging from 3000 Å to 6000 Å, of silicon oxide obtained from a liquid source (oxide from TEOS), the deposition of sacrificial planarization material (resist) and plasma etching of the oxide and of the resist until the strata of barrier polysilicon are uncovered.

According to a particular known technique, such final etching is executed with a suitable oxide/resist selectivity, that is a ratio between the etching rates of, say, 1.2/1.

Another known planarization process calls for the deposition of a stratum of Boron Phosphorus Silicon Glass, that is a silicon oxide doped with boron and phosphorus. This material has excellent capacities for thermal reflow, which allows a very uniform planarization; it is thus not necessary to use sacrificial material. Lastly a reactive ion etching is repeated twice.

Whichever way it is executed, the object of the planarization stage is to create a stratum of dielectric between the floating gate areas, leaving the barrier polysilicon uncovered. The thickness of the residual oxide which remains between the floating gate areas must be sufficiently high to reduce as much as possible the stray capacitance between the source and drain lines and the control gate lines which are subsequently superimposed on the barrier polysilicon, perpendicularly to the source and drain lines. With the known techniques the reduction of this stray capacitance is often not satisfactory.

The object of the present invention is to accomplish a planarization process for EPROM memory cell matrices with a table cloth and a half table cloth structure, whereby it is possible to obtain a thickness of residual oxide sufficient to cancel the stray capacitance between the source and drain lines and the control gates.

According to the invention such object is attained with a planarization process for EPROM memory cell matrices with a table cloth and a half table cloth structure comprising a semiconductor substrate, lines of source and drain parallel to and alternated with one another on said substrate, floating gate areas placed in a checker-board pattern between said lines of source and drain, a stratum of dielectric and a stratum of barrier polysilicon superimposed over and self-aligned with said floating gate areas, characterized in that it comprises the deposition of an oxide stratum obtained from a liquid source over the entire matrix structure, the subsequent deposition and distribution by rotation of sacrificial material having fluid characteristics, the so-called "spin-on-glass", and the etching of the two materials with a plasma having characteristics such as to determine a rate of removal of the sacrificial material which is lower than the rate of removal of the oxide.

The characteristics and the advantages of the present invention shall be made more clearly evident in a preferred embodiment of the present invention, illustrated as a non-limiting example in the enclosed drawings, wherein:

Fig.s 1 to 4 are cross-sectional views of a portion of a table cloth matrix during successive stages of the planarization process according to the invention.

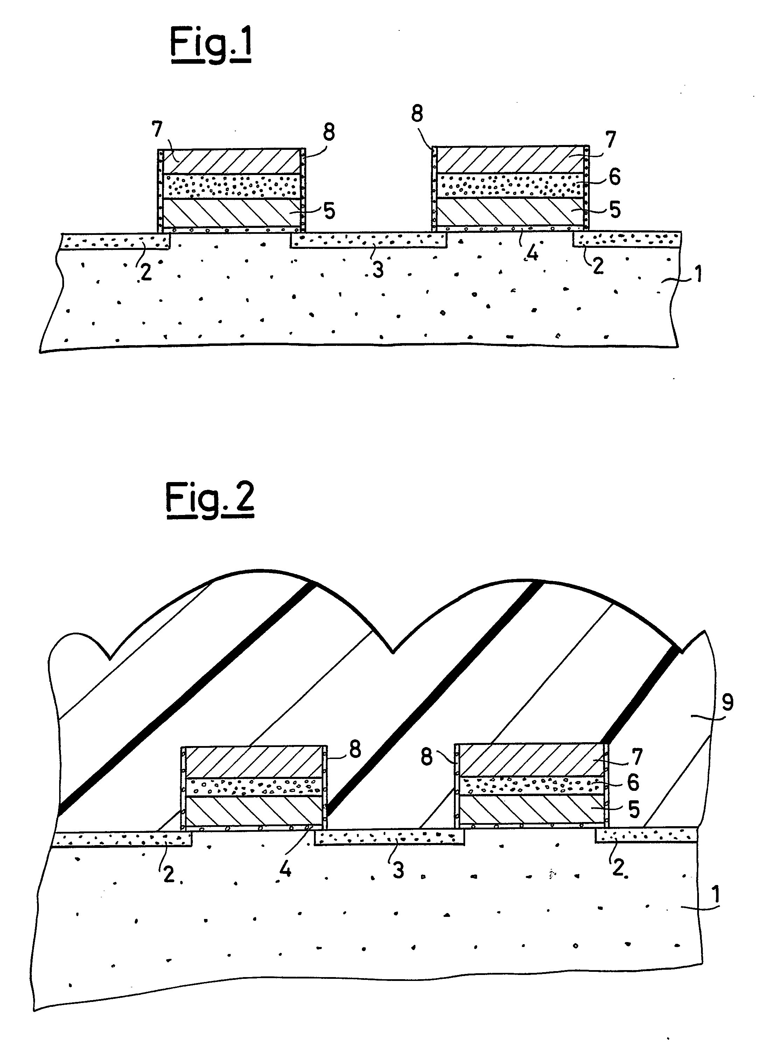

As is seen in Fig. 1, the structure before planarization consists of a semiconductor substrate 1, in particular of silicon, on whose surface there are obtained by dope diffusion parallel lines of source 2 and drain 3, constituting the so-called "bit lines".

Between the lines of source 2 and drain 3 gate oxide areas 4 are obtained, on which there are superimposed on successive strata a floating gate area 5, a dielectric area 6 and a barrier polysilicon area 7.

On the sides of each "package" formed by floating gate 5, dielectric 6 and polysilicon 7 and on the lines of source 2 and drain 3 there are oxide strata 8.

The first stage of the planarization process (Fig. 2) is the deposition of a liquid source oxide stratum 9 (oxide from TEOS-tetraethylorthosilicate), preferably having a thickness ranging from 0.6 to 1 micron (in relation to the distance between the floating gates 5, typically ranging from 0.8 to 1 micron).

TEOS has an excellent capacity for distributing itself in the uncovered areas among the different polysilicon strips; it is also an outstanding insulator.

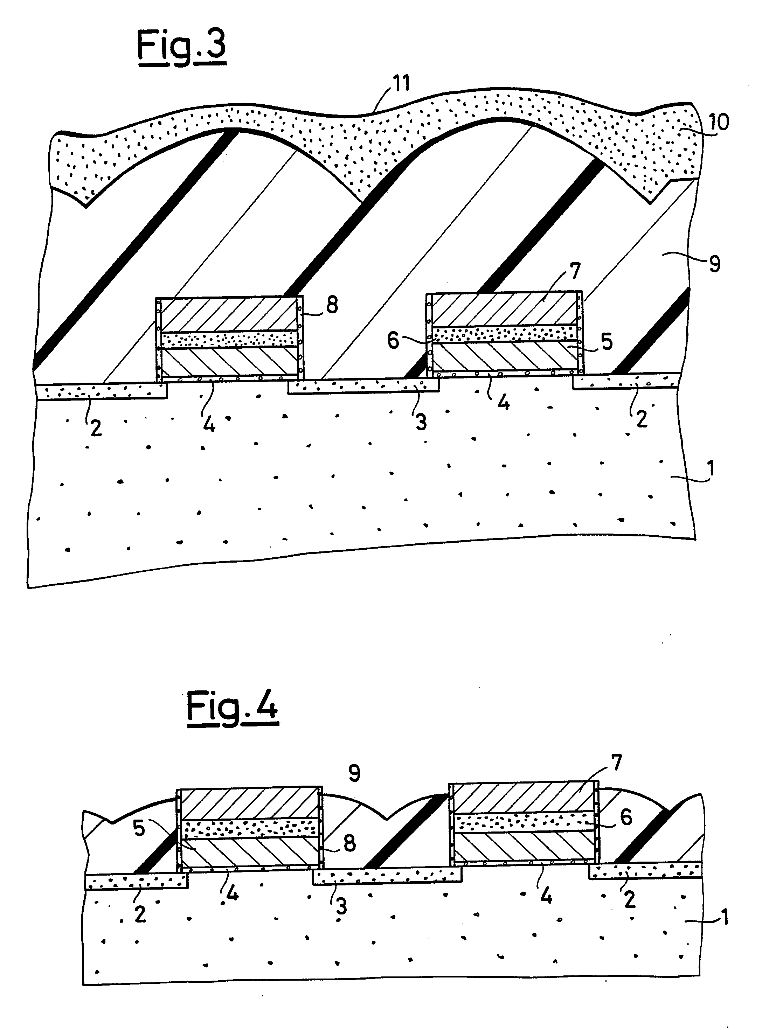

Subsequently (Fig. 3) there is deposited on the TEOS oxide 9 a stratum of sacrificial material 10, so-called "spin-on-glass" (SOG), which is distributed uniformly on the structure by rotation of the latter.

Sacrificial material of this type is described, for example, in the article "Spin-on Glass Films", June 9-10 1986 V-MIC Conf., 1986 IEEE.

The SOG 10 allows the formation of a surface 11 which is essentially flat, compensating for the variable shape of TEOS.

The thickness of the SOG stratum 10 ranges preferably from 3000 Å to 5000 Å.

The final stage of the planarization process (Fig. 4) is the etching with plasma, with which the SOG 10 is removed completely, while the TEOS 9 is etched until the barrier polysilicon 7 is uncovered, but without uncovering the dielectric 6.

Etching occurs with the "end-point" technique, that is, the optical emission of the structure is taken, which varies in relation to the removed and/or uncovered material. On the basis of such emission the etching end point is determined.

SOG is particularly suitable for this type of etching, since its optical emission is very evident.

Etching occurs with a plasma whereby it is possible to etch the SOG 10 at a rate which is lower than the etching rate of the TEOS 9; in this way it is possible to uncover the polysilicon 7 while still having available a good stratum of TEOS between one polysilicon package and the next (Fig. 4).

The use of SOG as sacrificial material is important because it has a reduced "loading" effect, that is, the etching rate on the part of the plasma on the SOG is uniform and does not depend on the uncovered area.

In this way the etching selectivity, that is, the ratio between the SOG and the TEOS etching rates, remains constant, equal to, say, SOG/TEOS = 0.5/1.

## Claims

1. Planarization process for EPROM memory cell matrices with a table cloth and a half table cloth structure comprising a semiconductor substrate (1), lines of source (2) and drain (3) parallel to and alternated with one another on said substrate (1), floating gate areas (5) placed in a checker-board pattern between said lines of source (2) and drain (3), a stratum of dielectric (6) and a stratum of barrier polysilicon (7) superimposed over and self-aligned with said floating gate areas (5), characterized in that it comprises the deposition of an oxide stratum (9) obtained from a liquid source over the entire matrix structure, the subsequent deposition and distribution by rotation of sacrificial material (10) having fluid characteristics, the so-called "spin-on-glass", and the etching of the two materials (9, 10) with a plasma having characteristics such as to determine a rate of removal of the sacrificial material (10) which is lower than the rate of removal of the oxide (9).

2. Planarization process according to claim 1, characterized in that said oxide (9) obtained from a liquid source is oxide from TEOS-tetraethylorthosilicate.

3. Planarization process according to claim 1, characterized in that the rate of removal of the sacrificial material (10) is equal to half the rate of removal of the oxide (9).

## Fig.1

## Fig.2

# Fig.3

# Fig.4